# EUROPEAN PATENT SPECIFICATION

(11) **EP 1 654 737 B1**
(45) Date of publication and mention of the grant of the patent: **22.09.2010**
(21) Application number: 04744667.9
(22) Date of filing: 28.07.2004
(51) Int. Cl.: G11C 27/02

(54) **TRACK-AND-HOLD CIRCUIT**
ABTAST- UND HALTESCHALTUNG
ECHANTILLONNEUR BLOQUEUR

(30) Priority: 04.08.2003 EP 03102417
(43) Date of publication of application: 10.05.2006
(73) Proprietor: NXP B.V., 5656 AG Eindhoven (NL)
(72) Inventor: GEELEN, Godefridus, J., G., M., NL-5656 AA Eindhoven (NL)
(74) Representative: Williamson, Paul Lewis
(86) International application number: PCT/IB2004/051314
(87) International publication number: WO 2005/013284

(56) References cited:
- WO-A-01/84716
- US-A- 5 350 952
- US-A- 5 384 570
- US-A1- 2002 084 808

## Description

This invention relates to a track-and-hold circuit and, more particularly, to a track-and-hold circuit for use in an analog-to-digital converter.

High speed analog-to-digital converts (ADC's) play a decisive role in the overall performance of many imaging, video and digital communication systems, and have been successfully developed using a number of different architectures.

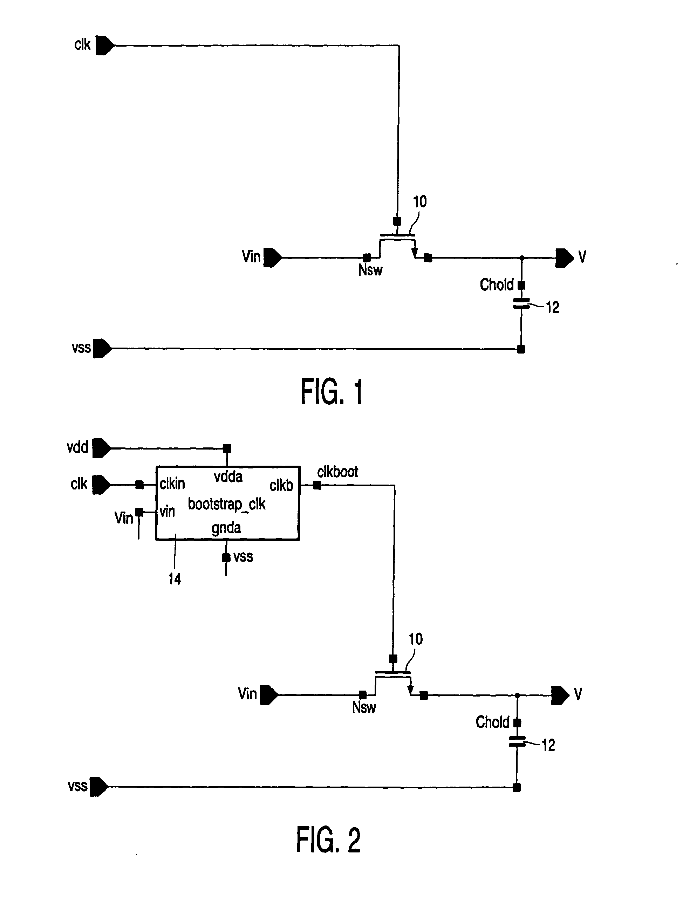

Referring to Fig. 1 of the drawings, there is illustrated a simple Track-and-Hold (T/H) circuit consisting of a switch 10 and a capacitor 12. The switch 10 can be realized using one or more MOS transistors; and is closed during a track mode of the circuit (when the capacitor charge tracks the input signal) and open during a hold mode of the circuit. There are a number of disadvantages associated with this configuration, including the fact that Ron of the switch 10 and charge injection to the capacitor 12 during switching-off is input signal dependent, and therefore introduce offset and distortion, which is clearly undesirable.

Referring to Fig. 2 of the drawings, a known solution to this problem is to provide a bootstrap circuit 14 between the clock clk and the gate of the switch 10. The bootstrap circuit 14 has an additional input terminal, and the resultant bootstrapped clock signal clkboot output from the bootstrap switch 14 is applied to the gate of the switch 10. In this way, the clock signal fed to the gate of the switch 10 follows the input signal: Vclkboot high = Vin + VDD. Now, the drive voltage Vs of the switch 10 is always equal to VDD and thus independent of Vin. As a result, distortion is suppressed, although the offset remains.

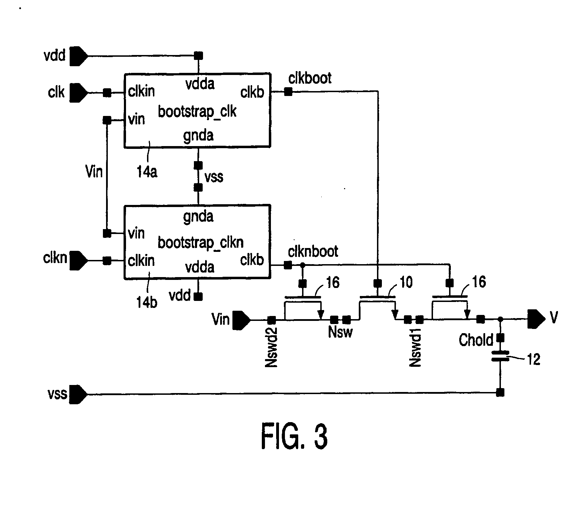

Referring to Fig. 3 of the drawings, a well known solution to this is to use dummy switches 16 which are clocked in anti-phase with the actual switch 10 and thereby compensate for the charge injection of the switch 10, so as to suppress the offset. As shown a first bootstrap switch 14a provides a bootstrapped clock signal to the gate of the switch 10, and a second bootstrap switch 14b provides a bootstrapped anti-phase clock signal to the gates of the dummy switches 16.

However, when the track-and-hold circuit is in hold mode, the clock on the dummy switches 16 is high and follows the input signal. This gives crosstalk to the sample capacitor 12 via the gate capacitance of the dummy switch 16, which again results in distortion. Furthermore, in order to achieve high bandwidth and low distortion, Vgs of the switch 10 should be maximal so as to minimize Ron of the switch 10. However, in the arrangement of Fig. 3, Vgs is only VDD - 0.5V.

US patent number 6,525,374 B1 describes a sample and hold circuit to sample and hold an input signal, the circuit including a load capacitor to hold the signal, a switch to control the charging of the load capacitor, and a boost circuit to control the operation of the switch. The boost circuit provides an increased voltage to the gate of the switch to avoid increasing the size of the switch and effectively lowering the on resistance of the switch. It compensates for variations of the threshold voltage on the switch and the effective on resistance of the sampling switch is kept substantially constant, thereby minimizing distortion of the sample signal.

United States patent US5,384,570 discloses a voltage storage circuit comprises a bootstrapped switch driving device including, potential offset generating circuitry.

We have now devised an improved arrangement.

In accordance with the present invention, there is provided a track-and-hold circuit according to claim 1. In one exemplary embodiment, the buffering means may comprise a MOS transistor, preferably a PMOS transistor.

Also in accordance with the present invention, there is provided an analog-to-digital converter including a track-and-hold circuit as defined above.

These and other aspects of the invention will be apparent from and elucidated with reference to the embodiment described hereinafter.

An embodiment of the present invention will now be described by way of example only and with reference to the accompanying drawings, in which:
Fig. 1 is a schematic circuit diagram of a track-and-hold circuit according to the prior art;
Fig. 2 is a schematic circuit diagram of an improved track-and-hold circuit according to the prior art;
Fig. 3 is a schematic circuit diagram of a further improved track-and-hold circuit according to the prior art;
Fig. 4 is a schematic circuit diagram of a bootstrap switch for use in an exemplary embodiment of the present invention; and
Fig. 5 is a schematic circuit diagram of a track-and-hold circuit according to an exemplary embodiment of the present invention.

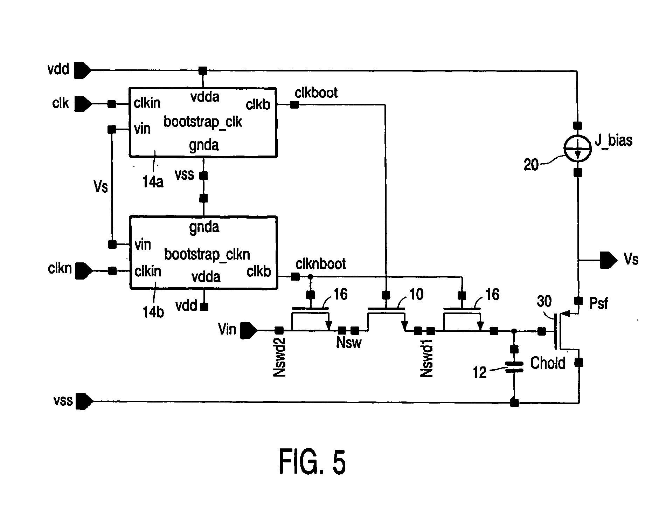

Referring to Fig. 5 of the drawings, a track-and-hold circuit according to an exemplary embodiment of the present invention comprises a switch 10 and a capacitor 12, as before. A first bootstrap switch 14a has as its inputs a clock signal clk and an input signal Vs which is a level shifted version of the tracked and held input signal Vin. The clock signal clkboot output from the first bootstrap switch 14a is applied to the gate of the switch 10, and now equals Vin + Vdd and Vlevelshift Levelshifting is done in the form of a current source 20 and buffer means 30. The drive voltage Vgs of switch 10 is now Vdd + Vlevelshift = Vdd + 0.5V, which is higher than in the arrangement of Fig. 3.

A second bootstrap switch 14b is provided, having as its inputs an anti-phase clock signal clk and the levelshifted input signal Vs. The anti-phase clock signal clknboot output from the second bootstrap switch 14b is applied to the gates of two dummy switches 16 connected on either side of the switch 10. Note that Vs is constant in hold mode so there is no crosstalk to the sample capacitor 12, as opposed to the case in the arrangement of Fig. 3.

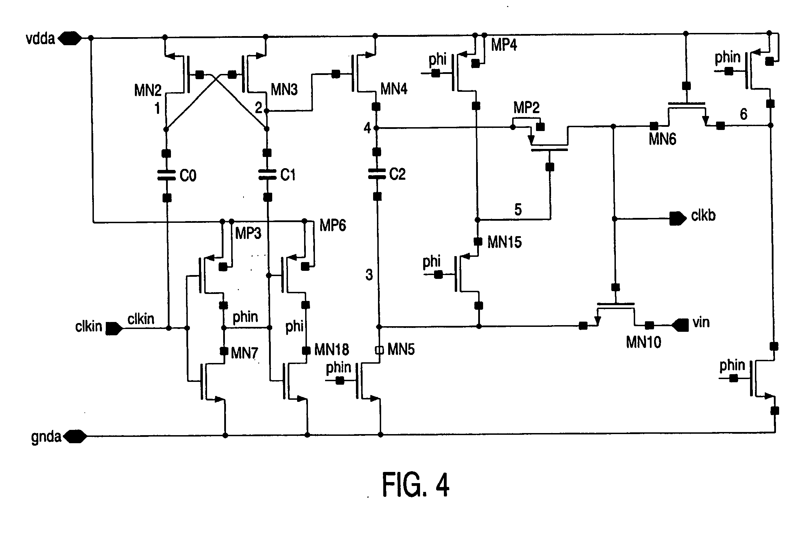

There are several different configurations of a bootstrap switch, one of which is illustrated in Fig. 4. Other implementations of bootstrap techniques are well-known in the art, and the present invention is not intended to be limited in this regard.

The track-and-hold circuit illustrated in Fig. 5 may be used as the input to, for example, an 8-bit analog-to-digital converter, in which configuration it can be shown to The track-and-hold circuit illustrated in Fig. 5 may be used as the input to, for example, an 8-bit analog-to-digital converter, in which configuration it can be shown to display good performance up to 500MHz, thereby proving the high bandwidth and low distortion of the present invention.

It should be noted that the above-mentioned embodiment illustrates rather than limits the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listen in any claim or the specification as a whole. The invention may be implemented by means of hardware comprising several distinct elements and by means of a suitably programmed computer. In a device claim enumerating several means, several of these mans may be embodied by one and the same item of hardware. The mere fact that certain measures are recited in mutually different dependent claims does not indicate that a combination of these measures cannot be used to advantage.

## Claims

1. A track-and-hold circuit having an input (Vin) and an output signal (V), a bootstrap switch (14a) having as its inputs a clock signal (clk) and an levelshifted input signal (Vs), said levelshifted input signal (Vs) being connected to said output signal (V) of said circuit via level shifting (20) and buffering means (30), the track-and-hold circuit further comprising a capacitor (12), said input signal of said track-and-hold circuit being connected to said capacitor (12) via a switch (10), said switch (10) being closed during a track mode of said circuit and open during a hold mode of said circuit, said levelshifted input signal (Vs) of said bootstrap switch (14a) being a level-shifted version of the tracked and held signal (Vin) and comprising said output signal of said track-and-hold circuit and being constant in hold mode, **characterized in that** the track-and-hold circuit further comprises two dummy switches (16) connected on either side of said switch, connecting said input signal to said capacitor, and which are clocked by a bootstrapped anti-phase clock signal (clknboot) in anti-phase to said switch, **in that** the track-and-hold circuit further comprises at least one further bootstrap switch (14b), said further bootstrap switch having at its inputs an anti-phase clock signal (clkn) and said levelshifted input signal and **in that** said levelshifted input signal (Vs) is connected to each of said two dummy switches (16) via said at least one further bootstrap switch (14b) and said bootstrapped anti-phase clock signal.

2. A track-and-hold circuit according to claim 1, wherein said buffering means (30) comprises a MOS transistor.

3. A track-and-hold circuit according to claim 2, wherein said MOS transistor is a PMOS transistor.

4. An analog-to-digital converter including a track-and-hold circuit according to any one of claims 1 to 3

5. An integrated circuit including an analog-to-digital converter according to claim 4.

## Patentansprüche

1. Folge-und-Halte-Schaltung, die einen Eingang (Vin) und ein Ausgangssignal (V), einem Bootstrap-Schalter (14a) aufweist, der an seinen Eingängen ein Taktsignal (clk) und ein pegelverschobenes Eingangssignal (Vs) aufweist, wobei das pegelverschobene Eingangssignal (Vs) mit dem Ausgangssignal (V) der Schaltung über Pegelverschiebungsmittel (20) und Puffermittel (30) verbunden ist, wobei die Folge-und-Halte-Schaltung ferner einen Kondensator (12) umfasst, wobei das Eingangssignal der Folge-und-Halte-Schaltung mit dem Kondensator (12) über einen Schalter (10) verbunden ist, wobei der Schalter (10) während eines Folgemodus der Schaltung geschlossen ist und während eines Haltemodus der Schaltung geöffnet ist, wobei das pegelverschobene Eingangssignal (Vs) des Bootstrap-Schalters (14a) eine pegelverschobene Version des verfolgten und gehaltenen Signals (Vin) ist und das Ausgangssignal der Folge-und-Halte-Schaltung umfasst und im Haltemodus konstant ist; **dadurch gekennzeichnet, dass** die Folge-und-Halte-Schaltung ferner zwei Blindschalter (16) umfasst, die an jeder Seite des Schalters angeschlossen sind, das Eingangssignal mit dem Kondensator verbinden und mittels eines geladenen Gegenphasentaktsignals (clknboot) in Gegenphase zu dem Schalter getaktet werden; dass die Folge-und-Halte-Schaltung ferner wenigstens einen weiteren Bootstrap-Schalter (14b) umfasst, wobei der weitere Bootstrap-Schalter an seinen Eingängen ein Gegenphasentaktsignal (clkn) und das pegelverschobene Eingangssignal aufweist; und dass das pegelverschobene Eingangssignal (Vs) mit jedem der zwei Schalter (16) über den wenigstens einen Bootstrap-Schalter (14b) und mit dem geladenen Gegenphasentaktsignal verbunden ist.

2. Folge-und-Halte-Schaltung nach Anspruch 1, wobei die Puffermittel (30) einen MOS-Transistor umfassen.

3. Folge-und-Halte-Schaltung nach Anspruch 2, wobei der MOS-Transistor ein PMOS-Transistor ist.

4. Analog-zu-Digital-Wandler, der eine Folge-und-Halte-Schaltung nach irgendeinem der Ansprüche 1 bis 3 enthält.

5. Integrierte Schaltung, die einen Analog-zu-Digital-Wandler nach Anspruch 4 enthält.

## Revendications

1. Circuit de poursuite et de maintien ayant un signal d'entrée (Vin) et un signal de sortie (V), un commutateur d'amorçage (14a) ayant comme entrées un signal d'horloge (clk) et un signal d'entrée décalé en niveau (Vs), ledit signal d'entrée décalé en niveau (Vs) étant raccordé audit signal de sortie (V) dudit circuit par l'intermédiaire de moyens de décalage de niveau (20) et de moyens de tamponnage (30), le circuit de poursuite et de maintien comprenant en outre un condensateur (12), ledit signal d'entrée dudit circuit de poursuite et de maintien étant raccordé audit condensateur (12) par l'intermédiaire d'un commutateur (10), ledit commutateur (10) étant fermé pendant un mode de poursuite dudit circuit et ouvert pendant un mode de maintien dudit circuit, ledit signal d'entrée décalé en niveau (Vs) dudit commutateur d'amorçage (14a) étant une version décalée en niveau du signal poursuivi et maintenu (Vin) et comportant ledit signal de sortie dudit circuit de poursuite et de maintien et étant constant en mode de maintien, **caractérisé par le fait que** ledit circuit de poursuite et de maintien comporte en outre deux commutateurs fictifs (16) raccordés de chaque côté dudit commutateur, raccordant ledit signal d'entrée audit condensateur, et qui sont commandés par un signal d'horloge amorcé en opposition de phase (clknboot), **par le fait que** le circuit de poursuite et de maintien comporte en outre au moins un autre commutateur d'amorçage (14b), ledit autre commutateur d'amorçage ayant sur ses entrées un signal d'horloge en opposition de phase (clkn) et ledit signal d'entrée décalé en niveau, et **par le fait que** ledit signal d'entrée décalé en niveau (Vs) est raccordé à chacun desdits deux commutateurs (16) par l'intermédiaire d'au moins un autre commutateur d'amorçage (14b) et dudit signal d'horloge amorcé en opposition de phase.

2. Circuit de poursuite et de maintien selon la revendication 1, dans lequel lesdits moyens de tamponnage (30) comprennent un transistor MOS.

3. Circuit de poursuite et de maintien selon la revendication 2, dans lequel ledit transistor MOS est un transistor PMOS.

4. Convertisseur analogique-numérique comportant un circuit de poursuite et de maintien selon l'une quelconque des revendications 1 à 3.

5. Circuit intégré comportant un convertisseur analogique-numérique selon la revendication 4.
